# EUROPEAN PATENT APPLICATION

(11) **EP 4 485 799 A1**
(43) Date of publication of application: **01.01.2025**
(21) Application number: 23217546.3
(22) Date of filing: 18.12.2023
(51) Int. Cl.: H03K 3/012, H03K 19/00

(54) **LEAKAGE COMPENSATED DYNAMIC LATCH**

(30) Priority: 29.06.2023 US 202318216424
(71) Applicant: INTEL Corporation, Santa Clara, CA 95054 (US)
(72) Inventor: THAPLOO, Anupama Ambardar, Folsom,, CA 95630 (US); PONNILETH RAJENDRAN, Ananthakrishnan, Rancho Cordova,, CA 95742 (US); IYER, Ganesan, Phoenix,, AZ 85048 (US)
(74) Representative: Viering, Jentschura & Partner mbB Patent- und Rechtsanwälte

(57) **Abstract**

Some embodiments include input stage of a latch to receive input data information and clock information; a memory node coupled to the input stage to store information based on the input data information; an output stage of the latch coupled to the memory node and including an output node to provide output data information based on the information stored at the memory node; a first circuit to provide a first circuit path between the memory node and a first node in the input stage; and a second circuit to provide a second circuit path between the memory node and a second node in the input stage.

## Description

### Technical Field

Embodiments described herein pertain to memory circuits. Some embodiments relate to dynamic latches.

### Background

Latches are widely used in many electronic devices or systems, such as computers, tablets, cellular phones, and internet of things (IoT). Latches are memory circuits used to store data. Different types of latches include dynamic latches and static latches. These latches store data in the form of electrical charge. A typical static latch can retain the value of the stored data for a relatively longer time interval than a typical dynamic latch. In a typical static latch, the charge that reflects the value of the stored data can remain relatively unchanged as long as power is provided to the static latch. A typical dynamic latch can operate at a higher speed than a typical static latch. However, a typical dynamic latch may retain the charge (that reflects the value of the stored data) for only a short time interval. Therefore, a device that includes dynamic latches usually has refresh cycles (refresh operations) to periodically refresh (e.g., renew) the charge store in the dynamic latch to keep the stored data valid for a specific (predetermined) time interval. Static latches may be used in place of dynamic latches to avoid refresh cycles. However, static latches typically have a larger size than dynamic latches. A larger size can cause static latches to consume more power than dynamic latches. Thus, dynamic latches are often preferable over static latches in a device where operating speed, device area, power consumption, or a combination of these factors, are the main concerns for that device. As technology advances, the size of some dynamic latches can be extremely small. At a certain small size, charge leakage may occur at transistors that form the dynamic latch. Charge leakage can cause the stored data in the dynamic latch to become invalid. A higher refresh rate may be used to keep the stored data valid before the leakage charge causes the stored data to become invalid. However, a higher refresh rate may be unsuitable for some devices. Further, a higher refresh rate leads to increased power consumption.

### Brief Description of the Drawings

FIG. 1 shows an apparatus in the form of a dynamic latch, according to some embodiments described herein.
FIG. 2 shows an apparatus in the form of another dynamic latch, according to some embodiments described herein.
FIG. 3 shows an apparatus in the form of another dynamic latch, according to some embodiments described herein.
FIG. 4 shows an apparatus in the form of a system (e.g., a machine) including the dynamic latch of FIG. 1, FIG. 2, or FIG. 3, according to some embodiments described herein.
FIG. 5 is a flowchart showing a method of operating an apparatus, according to some embodiments described herein.

### Detailed Description

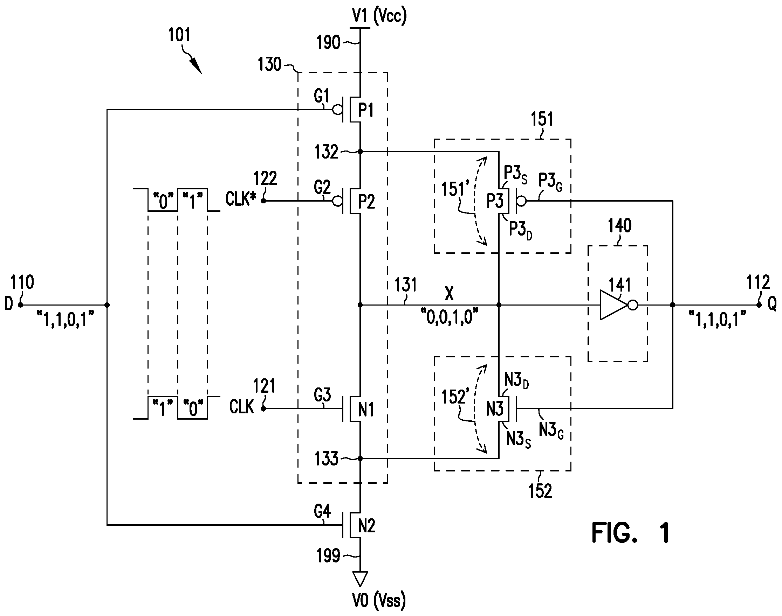

The techniques described herein involve a dynamic latch and compensation for charge leakage in the dynamic latch. The described dynamic latch includes a relatively small number of transistors that allows its size to be relatively small, suitable for high-speed operations in devices or systems that include the described dynamic latch. The described latch includes circuits to compensate charge leakage during a retention state of the dynamic latch. The compensation allows the dynamic latch to retain the value of data information stored in the dynamic latch valid for a relatively longer time interval than some conventional dynamic latches. This allows a device or system that includes that latch to have a lower data refresh rate, leading to reduced power consumption in such a device and system. These and other improvements and benefits of the described techniques are discussed in more detail below with reference to FIG. 1 through FIG. 5.

FIG. 1 shows an apparatus in the form of a latch 101, according to some embodiments described herein. Latch 101 is a dynamic latch. Latch 101 can operate to receive data information D at a node (e.g., data input node) 110 and provide (pass) the received data information D to a node (e.g., data output node) 112 as data information Q. Data information D and data information Q can be viewed as input data information and output data information, respectively. Latch 101 can also store data information X at a node (e.g., a memory node) 131. Node 131 can be structured as a charge storage node (e.g., a memory node) to store data information X in the form of a charge at node 131. The value of information X is based on the value of data information D. Each of data information D, data information X, and data information Q can be in the form of bits. Latch 101 can receive one bit of data information D at a time at node 110. Latch 101 can provide one bit of data information Q at a time at node 112. Latch 101 can store one bit of data information X at a time at node 131.

As shown in FIG. 1, latch 101 can include an input stage (e.g., an input driver stage) 130, a node (e.g., memory node) 131, and an output stage (e.g., an output driver stage) 140, a circuit 151, a circuit 152, a clock node 121, a clock node 122, a supply node 190, and a supply node 199. Input stage 140 can include transistors P1, P2, N1, and N2. Output stage 140 can include an inverter 141. Supply node 190 can be coupled to (e.g., can receive) a voltage V1 (e.g., supply voltage Vcc). Supply node 199 can be coupled to (e.g., can receive) a voltage V0 (e.g., supply voltage Vss) that can be 0V (e.g., ground potential).

As shown in FIG. 1, transistors P1, P2, N1, and N2 can be coupled in series with each other between supply nodes 190 and 199. Transistors P1, P2, N1, and N2 can have respective gates G1, G3, G4, and G2. The non-gate terminals (e.g., sources and drains) of transistors P1, P2, N1, and N2 can be coupled to each other at respective nodes 131, 132, and 133. As shown in FIG. 1, node (e.g., memory node) 131 is between transistors N1 and P2, node 132 is between transistors P1 and P2, and node 133 is between transistors N1 and N2. Each of nodes 131, 132, and 133 can be a common node shared by (coupled to) a source and a drain of two respective transistors (e.g., two adjacent transistors) among transistors P1, P2, N1, and N2. In this description, source and drain of a transistor are used interchangeably.

Transistors P1 and P2 can have a different transistor type from transistors N1 and N2. In an example, transistors P1 and P2 can include p-type transistors, and transistors N1 and N2 ca include n-type transistors. An example of a p-type transistor includes a p-channel metal-oxide-semiconductor (PMOS) transistor. An example of an n-type transistor includes an n-channel metal-oxide-semiconductor (NMOS) transistor. Transistors P1, P2, N1 and N2 can be formed using complementary metal-oxide-semiconductor (CMOS) process. Thus, in an example, transistors P1, P2, N1, and N2 can include CMOS transistors. This description uses PMOS and NMOS transistors as an example. However, other types transistors can be used.

As shown in FIG. 1, inverter 141 can includes an input node coupled to node 131 and an output node coupled to node 112. Inverter 141 can include CMOS transistors (not shown).

Circuit 151 can include a transistor P3 (e.g., only one transistor P3) coupled to nodes 131, 132, and 112. Transistor P3 can be coupled in parallel with transistor P2 between node 131 and node 132. As shown in FIG. 1, transistor P3 can include a p-type transistor (e.g., PMOS). Transistor P3 can include a terminal P3_{D} (e.g., drain) coupled (e.g., directly coupled) to node 131, a terminal P3s (e.g., source) coupled (e.g., directly coupled) to node 132, and a gate P3_{G} coupled (e.g., directly coupled) to node 112. Gate P3_{G} of transistor P3 can be controlled (e.g., turned on or turned off) by the value (e.g., value of the bit) of data information Q (at node 112), which is based on the value (e.g., value of the bit) of data information X (at node 131). Latch 101 can include a circuit path (e.g., a current path) 151' that includes transistor P3. Circuit path 151' is part of a circuit path (e.g., a current path from node 131 to supply node 190 through transistors P3 and P1) coupled between node 131 and supply node 190. Thus, as shown in FIG. 1, circuit 151 can provide a circuit path (e.g., circuit path 151') between node 131 and node 132 in which the circuit path (e.g., circuit path 151') is part of a path between node 131 and supply node 190.

Circuit 152 can include a transistor N3 (e.g., only one transistor N3) coupled to nodes 131, 133, and 112. Transistor N3 can be coupled in parallel with transistor N1 between node 131 and node 133. As shown in FIG. 1, transistor N3 can include an n-type transistor (e.g., NMOS). Transistor N3 can include N3_{D} (e.g., drain) coupled (e.g., directly coupled) to node 131, a terminal N3s (e.g., source) coupled (e.g., directly coupled) to node 132, and a gate N3_{G} coupled (e.g., directly coupled) to node 112. Gate N3_{G} of transistor N3 can be controlled (e.g., turned on or turned off) by the value (e.g., value of the bit) of data information Q (at node 112), which is based on the value (e.g., value of the bit) of data information X (at node 131). Thus, gate N3_{G} of transistor N3 and gate N3_{G} of transistor P3 can be controlled by data information (e.g., data information Q) at the same node (e.g., node 112). Latch 101 can include a circuit path (e.g., a current path) 152' that includes transistor N3. Circuit path 152' is part of a circuit path (e.g., a current path from node 131 to supply node 199 through transistors N3 and N2) coupled between node 131 and supply node 199. Thus, as shown in FIG. 1, circuit 152 can provide a circuit path (e.g., circuit path 152') between node 131 and node 133 in which the circuit path (e.g., circuit path 152') is part of a path between node 131 and supply node 199.

Thus, in the example of FIG. 1, circuits 151 and 152 of latch 101 can include a relatively smaller number of transistors (e.g., only two transistors P3 and N3). The small number of transistors allows the overall size of latch 101 to be relatively small, suitable for it to be included in circuitry (e.g., high-speed circuitry) in devices or systems that include the described latch 101. Such circuity can include or can be part of a clock distribution network (e.g., clock spines), data paths, register circuitry, sequential circuitry, and other types of circuitries. Further, the smaller size allows latch 101 to consume a relatively small amount of power.

As shown in FIG. 1, clock nodes 121 and 122 can be coupled to gates G2 and G3, respectively, of transistors P2 and N1, respectively. Clock node 121 can be configured to receive a clock signal CLK. Clock node 122 can be configured to receive a clock signal CLK*. Clock signal CLK* is an inversion (is an inverted version) of clock signal CLK, and vice versa. Clock signals CLK and CLK* can have the same frequency. Clock signals CLK and CLK* are clock information. In latch 101, clock information (e.g., clock signals CLK and CLK*) is different from data information (e.g., input data information D) in that the clock information is used as timing information (e.g., timing signal or timing signals) to receive the data information and store the data information.

FIG. 1 shows waveforms indicating a timing relationship between clock signals CLK and CLK*. As shown in FIG. 1, clock signal CLK can have two different phases: a phase associated with CLK = "0" and a phase associated with CLK ="1". The term CLK = "1" means that clock signal CLK has a higher level (e.g., level corresponding to logic "1" or binary "1"). Term CLK = "0" means that clock signal CLK has a lower level (e.g., level corresponding to logic "0" or binary "0"). As shown in FIG. 1, clock signal CLK* can also have two different phases: a phase associated with CLK* = "0" and a phase associated with CLK* ="1". The term CLK* = "0" means that clock signal CLK* has a lower level (e.g., level corresponding to logic "0" or binary "0"). As shown by the waveforms of clock signal CLK and CLK* in FIG. 1, for a given time interval (e.g., one-half of the period of clock signal CLK), clock signals CLK and CLK* have opposite phases, such that when CLK = "1", CLK = "0", and when CLK = "0", CLK* = "1".

Latch 101 can use clock signal CLK to control (e.g., turn on or turn off) transistor N1. For example, when CLK = "1", it causes transistor N1 to turn on (e.g., to conduct current). When CLK = "0", it causes transistor N1 to turn off (e.g., not to conduct current). Latch 101 can use clock signal CLK* to control (e.g., turn on or turn off) transistor P2. For example, when CLK* = "0", it causes transistor P2 to turn on. When CLK* = "1", it causes transistor P2 to turn off. Since clock signals CLK and CLK* have opposite phases during a particular time interval, transistors P2 and N1 can be turned on during the same time interval and turned off during the same time interval.

Thus, when CLK = "1" (CLK* = "0"), transistors P2 and N1 are turned on. When transistors P2 and N1 are turned on, a circuit path (e.g., a current path) can be formed either between node 131 and supply node 190 or between node 131 and supply node 199, depending on the value of data information D received at (provided to) node 110. When CLK = "0" (CLK* = "1"), transistors P2 and N1 are turned off. When transistors P2 and N1 are turned off, a circuit path is not formed between node 131 and supply node 190 or between node 131 and supply node 199, regardless of the value of data information D.

Data information (e.g., input data information) D can include bits of information that can be received one bit at time based on timing (e.g., the frequency) of clock signals CLK and CLK*. Each bit of data information can have a binary value of either "0" (binary zero) or "1" (binary one). In this description, the term D = "0" means that a bit of data information D received at (provided to) node 110 at a particular time has a value of binary zero ("0"). The term D = "1" means that a bit of data information D received at (provided to) node 110 at a particular time has a value of binary one ("1"). FIG. 1 shows an example where data information D (received at node 110) has four bits with four respective binary values of "1,1,0,1".

Node 131 can store data information X based on data information D received at node 110. Node 131 can store one bit of data information X at a time. The value of the bit stored at node 131 is opposite from (an inverted version of) the value of the bit of data information D. Thus, based on the above example where the values of four bits of data information D received (received one bit at a time) at node are "1,1,0,1", the values of four corresponding bits stored (stored one bit at a time) at node 131 are "0,0,1,0", as shown in FIG. 1. In this description, the term X = "0" means that a bit of data information X stored at (retained at) node 131 at a particular time has a value of binary zero ("0"). The term X = "1" means that a bit of data information X stored at (retained at) node 131 at a particular time has a value of binary one ("1").

Node 112 can provide (e.g., output) data information (e.g., output data information) Q based on data information X at node 131. Node 131 can provide one bit of data information X at a time. The value of the bit provided at node 112 is opposite from (an inverted version of) the value of the bit of data information X and the same as the values of the bit at node 110. Thus, in the above example where latch 101 receives four bits having values of "1,1,0, 1", the values of four corresponding bits provided at node 112 are also "1,1,0,1", as shown in FIG. 1. In this description, the term Q = "0" means that a bit of data information Q provided (outputted) at node 112 at a particular time has a value of binary zero ("0"). The term Q = "1" means that a bit of data information Q provided (outputted) at node 112 at a particular time has a value of binary one ("1").

Latch 101 can include a write state and a retention state. Latch 101 can enter the write state (e.g., after exiting the retention state) when CLK = "1" (CLK* = "0"). Thus, transistors P2 and N1 are turned on in the write state. Transistors P1, P2, N1, and N2 can form an input driver to drive data information D from node 110 to node 131 as data information X during the write state. Latch 101 can retain data information X at node 131 during the retention state.

During the write state, latch 101 can receive, at node 110, a bit of data information D and store (e.g., write) the received bit as data information X in the form of a charge (amount of charge) at node 131. The bit of data information D received at data input node can have a value of "0" or "1" (i.e., D = "0" or D = "1"). The value of the bit of data information X at node 131 is based on (e.g., having a value opposite from) the value of the bit of data information D. For example, if D = "0", then X = "1". In another example, if D = "1", then X = "0".

Latch 101 can enter the retention state (e.g., after exiting the write state) when CLK = "0" (CLK* = "1"). Transistors P2 and N1 are turned off during the retention state. During the retention time, latch 101 can retain (keep) the value (e.g., X = "0" or X = "1") of the stored bit of data information X at node 131 valid unit the next write state (or the next refresh cycle).

Latch 101 can be included in a device or system (not shown) that can perform refresh cycles (refresh operations) to keep the value of the stored bit of data information X at node 131 valid for a specific time interval (e.g., for at least one period of clock signal CLK). The refresh cycle can be performed at a refresh rate to maintain (or refresh) the amount of charge at node 131, such that the amount of charge at node 131 can reflect the value (intended value) of the stored bit for a specific time interval. The specific time interval can be the time interval between one refresh cycle to the next refresh cycle. Power consumption can be proportional to the refresh rate, such that the higher the refresh rate, the higher the power consumption, and the lower the refresh rate, the lower the power consumption,

The following description give some example operations of latch 101 during a write state and a retention state where different values (e.g., D "1" and D = "0") of data information D are provided to input node 110 during different times.

The following example of a write state assumes that D = "1" is received at node 110 during a write state of latch 101. In this example (e.g., a current write state), latch 101 receives a bit of D = "1" (at node 110) and stores the received bit as a bit of X = "0" (at node 131). Latch 101 provides (e.g., outputs) a bit of Q = "1" at node 112.

Latch 101 operates in the write state (D = "1") in this example, as follows. In the write state, CLK = "1" and CLK* = "0". CLK* = "0" causes transistor P2 to turn on. D = "1" (assumed in this example) causes transistor P1 to turn off. Thus, a conductive path through transistors P1 and P2 is not formed between node 131 and supply node 190. CLK = "1" in the write state causes transistor N1 to turn on. D = "1" causes transistor N2 to turn on. The turned-on transistors N1 and N2 form a conductive path that couples node 131 to supply node 199. Node 131 is discharged to supply node 199 through transistors N1 and N2. Voltage V0 (e.g., ground) at supply node 199 corresponds to "0". Thus, node 131 has X = "0" in this example (e.g., current write state).

Latch 101 can operate in the retention state (X = "0") in this example, as follows. In the retention state, CLK = "0" and CLK* = "1". CLK* = 1 causes transistor P2 to turn off. CLK = "0" causes transistor N1 to turn off. Thus, node 131 is isolated (e.g., electrically isolated) from supply node 190 and from supply node 199. This allows node 131 to retain the value of X = "0". However, the value of X = "0" may change to X = "1" in some situations. For example, in the retention state in this example, D = "0" at node 110 may occur. This can be due to data information D returning to (flipping black to) its previous value (e.g., flipped back value) D = "0" after (e.g., right after) the current write state (D = "1") when CLK = "0" in the current retention state. In the current retention state, D = "0" (e.g., flipped back value) causes transistor P1 to turn on. Due to charge leakage (e.g., from smaller node technology, or temperature effects, or both), transistor P2 (in the current retention state) can leak charge and start charging node 131 through the turned-on transistor P1. This can change (e.g., increase) the charge at node 131 (which has X = "0" in the current retention state). Depending upon the parasitic capacitance (which is relatively low) associated with node 131, the change (e.g., increase) in the charge at node 131 (e.g., caused by charge leakage at transistor P2) may change X = "0" (intended to value to retain) to X = "1" (invalid value) if CLK = "0" remains unchanged in the current retention state. For example, CLK = "0" can remain unchanged if the next write state (or the next refresh cycle) does not occur before valid X = "0" changes to invalid X = "1". The change of X = "0" to X = "1" also causes Q = "1" (intended value) to change to Q = "0" (invalid value). The situation described here (where X = "0" may change to X = "1", causing invalid data information) assumes that circuit 152 is excluded from (not included in) latch 101.

Circuit 152 can operate to prevent the situation above (e.g., X = "0" changes to X = "1") from occurring in order to retain the validity of data information X stored at node 131 for a relatively longer time interval in comparison with similar conventional dynamic latches that do not include a circuit like circuit 152. As shown in FIG. 1, transistor N2 is turned off because D = "0" (flipped back value) in the current retention state. The turned-off transistor N2 may not provide a counter balance to compensate charge leakage caused by transistor P2 (as described above). However, circuit 152 can operate to provide this compensation. As shown in FIG. 1, gate N3_{G} is coupled to node 112, at which Q = "1" (current write state and retention state). Q = "1" causes transistor N3 to turn on and activate circuit path 152' (e.g., enable circuit path 152' to conduct current). This can provide a path (through transistor N3) for an amount of charge to discharge from node 131. This amount of charge can at least match the amount of charge going from supply node 190 to node 131 (through transistors P1 and P2) due to charge leakage caused by transistor P2. As a result, the amount of charge at node 131 can remain close to its intended value (e.g., value corresponding to X = "0" in the current retention state) until the next write state or the next refresh cycle.

Thus, as described above, the inclusion of circuit 152 allows latch 101 to compensate the change (e.g., increase) in the amount of charge (due to charge leakage through transistors P1 and P2) that may occur at node 131 to allow retention of valid data information X at node 131 and valid data information Q at node 112 for a relatively longer time interval in comparison with similar conventional dynamic latches. This can improve performance (e.g., higher data rate) of latch 101 and the device or system that includes latch 101 in comparison with similar conventional dynamic latches. Further, a longer data retention of latch 101 can allow it to be used in place of some conventional static latches that normally consume more power than dynamic latches. Thus, the inclusion of circuit 152 allows latch 101 to save more power if it is used in a device or system if such device or system uses latch 101 instead of some conventional static latches. Moreover, the inclusion of circuit 152 provides an option for a device or system that includes latch 101 to have a relatively lower refresh rate because data retention at node 131 can be relatively longer than that of similar conventional dynamic latches. Lower refresh rates can lead to lower power consumption in latch 101 and a device or system that includes latch 101 in comparison with similar conventional dynamic latches.

The above example assumes that D = "1" is received at node 110 during a write state of latch 101. However, if D = "0" is received at node 110, latch 101 can enter another write state (and another retention state) and operate in a similar but opposite way to provide similar improvements and benefits like those described above.

The following example of a write state assumes that D = "0" is received at node 110 during a write state of latch 101. In this example (e.g., a current write state), latch 101 stores D = "0" (received at node 110) as X = "1" (stored at node 131) and provides (e.g., outputs) Q = "0" at node 112 (i.e., Q = "0" and D = "0" in this example).

Latch 101 operates in a write state (D = "0") in this example, as follows. In a write state, CLK = "1" and CLK* = "0". CLK = "1" causes transistor N1 to turn on. D = "0" (assumed in this example) causes transistor N2 to turn off. Thus, a conductive path through transistors N1 and N2 is not formed between node 131 and supply node 199. CLK* = "0" causes transistor P2 to turn on. D = "0" causes transistor P1 to turn on. The turned-on transistors P1 and P2 form a conductive path that couples node 131 to supply node 190. Node 131 is charged to supply node 190 through transistors P1 and P2. Voltage V1 (e.g., voltage Vcc) at supply node 190 correspond to "1". Thus, node 131 has X = "1" in this example (e.g., current write state).

Latch 101 can operate in a retention state (X = "1") in this example, as follows. In a retention state, CLK = "0" and CLK* = "1". CLK* = 1 causes transistor P2 to turn off. CLK = "0" causes transistor N1 to turn off. Thus, node 131 is isolated (e.g., electrically isolated) from supply node 190 and from supply node 199. This allows node 131 to retain the value of X = "1". However, the value of X = "1" may change to X = "0" in some situations. For example, in the retention state in this example, D = "1" at node 110 may occur. This can be due to data information D returning to (flipping black to) its previous value (flipped back value) of D = "1" after (e.g., right after) the current write state (D = "0") when CLK = "0" in the current retention state. In the current retention state, D = "1" (e.g., flipped back value) causes transistor N2 to turn on. Due to charge leakage (e.g., from smaller node technology, or temperature effects, or both), transistor N1 (in the current retention state) can leak charge and start discharging node 131 through the turned-on transistor N2. This can change (e.g., decrease) the charge at node 131 (which has X = "1" in the current retention state). Depending upon the parasitic capacitance (which is relatively low) associated with node 131, the change (e.g., decrease) in the charge at node 131 (e.g., caused by charge leakage at transistor N1) may change X = "1" (intended to value to retain) to X = "0" (invalid value) if CLK* = "1" remains unchanged in the current retention state. For example, CLK* = "1" can remain unchanged if the next write state (or the next refresh cycle) does not occur before valid X = "1" changes to invalid X = "0". The change of X = "1" to X = "0" also causes Q = "0" (intended value) to change to Q = "1" (invalid value). The situation described here (where X = "1" may change to X = "0", causing invalid data information) assumes that circuit 151 is excluded from (not included in) latch 101.

Circuit 151 can operate to prevent the situation above (e.g., X = "1" changes to X = "0") from occurring in order to retain the validity of data information X stored at node 131 for a relatively longer time interval in comparison with similar conventional dynamic latches that do not include a circuit like circuit 151. As shown in FIG. 1, transistor P1 is turned off because D = "1" (flipped back value) in the current retention state. The turned-off transistor P1 may not provide a counter balance to compensate charge leakage caused by transistor N1 (as described above). However, circuit 151 can operate to provide this compensation. As shown in FIG. 1, gate P3_{G} is coupled to node 112, at which Q = "0" (current write state and retention state). Q = "0" causes transistor P3 to turn on and activate circuit path 152' (e.g., enable circuit path 152' to conduct current). This can provide a path (through transistor P3) for an amount of charge going to node 131. This amount of charge can at least match the amount of charge discharging to supply node 199 from node 131 (through transistors N1 and N2) due to charge leakage caused by transistor N1. As a result, the amount of charge at node 131 can remain close to its intended value (e.g., value corresponding to X = "1" in the current retention state) long enough until the next write state or the next refresh cycle.

Thus, as described above, the inclusion of circuit 151 allows latch 101 to compensate the change (e.g., increase or decrease) in the amount of charge (due to charge leakage through transistors N1 and N2) that may occur at node 131 to allow retention of valid data information X at node 131 and valid data information Q at node 112 for a relatively longer time interval in comparison with similar conventional dynamic latches. This can improve performance (e.g., increase data rate) of latch 101 and the device or system that includes latch 101 in comparison with similar conventional dynamic latches. Further, a longer data retention of latch 101 can allow it to be used in place of some conventional static latches that normally consume more power than dynamic latches. Thus, the inclusion of circuit 151 allows latch 101 to save more power if it is used in a device or system if such device or system uses latch 101 instead of some conventional static latches. Moreover, the inclusion of circuit 151 provides an option for a device or system that includes latch 101 to have a relatively lower refresh rate because data retention at node 131 can be relatively longer than that of similar conventional dynamic latches. Lower refresh rates can lead to lower power consumption in latch 101 and a device or system that includes latch 101 in comparison with similar conventional dynamic latches.

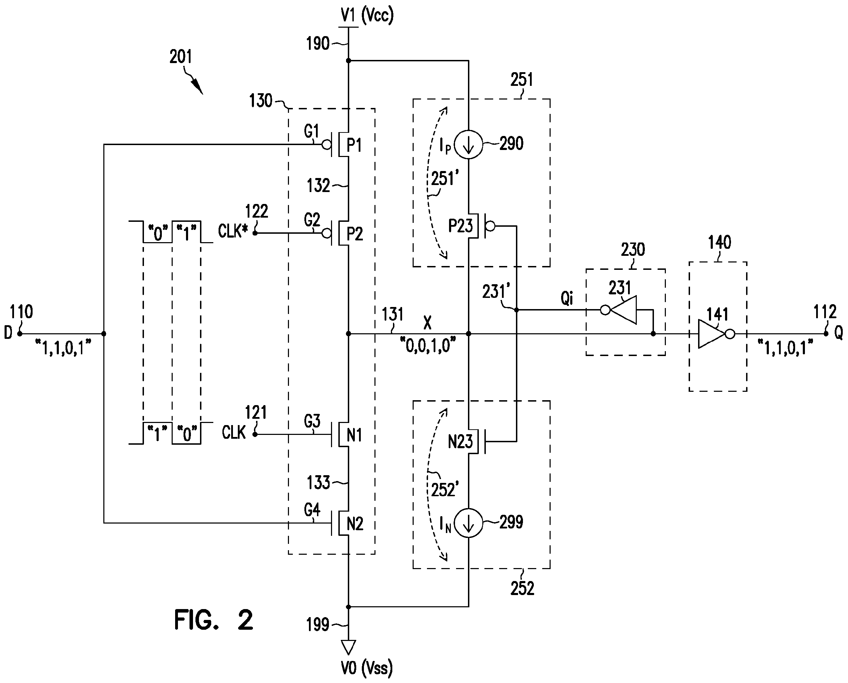

FIG. 2 shows an apparatus in the form of a latch 201, according to some embodiments described herein. Latch 201 is a dynamic latch. Latch 201 can include some elements that are similar to (or the same as) the elements of latch 101 of FIG. 1. Similar or same elements between latches 101 and 201 are given the same labels. For example, like latch 101 in FIG. 1, latch 201 in FIG. 2 can include input stage 130 (e.g., transistors P1, P2, N1, and N2), and output stage (e.g., inverter 141). For simplicity, descriptions of similar or the same elements between latches 101 and 201 are not repeated. Differences between latches 101 and 201 include a circuit 251, a circuit 252, and a circuit 230 of latch 201.

As shown in FIG. 2, circuit 251 can be coupled to node (e.g., memory node) 131, supply node 190, and circuit 230. Circuit 230 can include an inverter 231, which can include CMOS transistors (not shown). Inverter 231 can include an input node coupled to node 131, and an output node coupled to a node 231' in circuits 251 and 252. Node 231' can be a common node coupled to circuits 251 and 252. For example, node 231' can be a common gate of transistors P23 and N23.

Circuit 251 can be coupled to node 131, supply node 190, and circuit 230. Circuit 251 can include transistor (e.g., PMOS transistor) P23 and a current generator (e.g., current source) 290. Transistor P23 and current generator 290 can form (or can be part of) a circuit path (e.g., a current path) 251' between node 131 and supply node 190. Current generator 290 can generate (e.g., can source) a current Iₚ on circuit path 251'. Current generator 290 can be structured to be a relatively weak current generator, such that current Iₚ can be relatively small. A weak current generator 290 allows proper operation of latch 201 during a write state (e.g., when D = "1"), as described below.

Circuit 252 can be coupled to node 131, supply node 199, and circuit 230. Circuit 252 can include transistor (e.g., NMOS transistor) N23 and a current generator (e.g., current sink) 299. Transistor N23 and current generator 299 can form (or can be part of) a circuit path (e.g., a current path) 252' between node 131 and supply node 199. Current generator 299 can generate (e.g., can sink) a current I_{N} on circuit path 252'. Current generator 299 can be structured to be a relatively weak current generator, such that current I_{N} can be relatively small. A weak current generator 299 allows proper operation of latch 201 during a write state (e.g., when D = "0"), as described below.

Latch 201 can include a write state and a retention state similar to those of latch 101. In a write state in latch 201, data information D can be received at node 110 and stored as data information X at node 131. In a retention state, latch 201 can retain data information X and operate to compensate charge leakage that may occur at node 131 in order to keep the value of data information X at node 131 valid for a specific time interval (e.g., based a refresh rate).

As shown in FIG. 2, the input node of inverter 231 can receive data information X at node 131. Inverter 231 can provide control information Qi at its output node, which is coupled to node 231'. Thus, the value of control information Qi is opposite from the value of data information X at node 131. For example, if X = "0", then Qi = "0". If X = "1", then Qi = "1".

Circuit 230 operate to provide control information to circuits 251 and 252 based on information X stored at node 131. For example, circuit 230 (including inverter 231) can operate to make a selection of which circuit path (e.g., current path) between circuit paths 251' and 252' to use in order to compensate charge leakage that may occur at node 131 during a retention state. The selection can be based on the value of data information X at node 131, which can be used as feedback information for the compensation. Since control information Qi (at node 231') is based on information X (at node 131), control information Qi can also be viewed as feedback information (for the compensation) to control circuit 251 (e.g., control the gate of transistor P23) and control circuit 252 (e.g., control the gate of transistor N23)

For example, when Qi = "1" (indicating that X = "1"), inverter 231 selects circuit path 251' for the compensation. In this example, since X = "1", Qi = "0". Qi = "0" causes transistor P23 to turn on. The turned-on transistor P23 activates circuit path 251' and current generator 290 (e.g., enable circuit path 251' to conduct current). This allows node 131 to charge (e.g., in the form of current Iₚ) to supply node 190 to compensate charge leakage that may occur at transistor N1 (through transistor N2) to supply node 199. This compensation can retain the value of X = "1" at node 131 for a relatively longer time interval (e.g., longer than that of latch 201 without circuit 251).

In another example, when Qi = "0" (indicating that X = "0"), inverter 231 selects circuit path 252' for the compensation. In this example, since X = "0", Qi = "1". Qi = "1" causes transistor N23 to turn on. The turned-on transistor N23 activates circuit path 252' and current generator 299 (e.g., enable circuit path 252' to conduct current). This allows node 131 to discharge (e.g., in the form of current I_{N}) to supply node 199 to compensate charge leakage that may occur at transistor P2 (through transistor P1) to supply node 190. This compensation can retain the value of X = "0" at node 131 for a relatively longer time interval (e.g., longer than that of latch 201 without circuit 252).

In a write state, data information D written from node 110 to the node 131 by the input driver (formed by transistors P1, P2, N1, and N2) may initially face contention from either current generator 290 or current generator 290 from node 131, depending on the value of data information D. However, since current generators 290 and 299 are structured to be relatively weak current generators (e.g., current Iₚ and I_{N} are relatively small), the input driver (formed by transistors P1, P2, N1, and N2) can overpower node 131 and change the value of data information X, thereby deactivating the opposite polarity current on circuit path 251' or 252'.

The following example describes an example write state where "1" (e.g., X = "1") is to be written to node 131 while node 131 currently has X = "0" (which is being held by active circuit path 252') previously written in a previous write state. In this example, D = "0" and CLK* = "0", and transistors P1 and P2 are turned on. The turned-on transistors P1 and P2 can overpower transistor N23 and current generator 299. Transistors P1 and P2 couple node 131 to supply node 190 and deactivate circuit path 252' (e.g., disable circuit path 252' from conducting current). This causes X = "0" (written in a previous write state) to change to the intended written value X = "1" (which corresponds to the value of voltage V1 at supply node 190) in the current write state.

The following example describes an example current write state where "0" (e.g., X = "0") is to be written to node 131 while node 131 currently has X = "1" (which is being held by active circuit path 251') previously written in a previous write state. In this example, D = "1" and CLK* = "0", and transistors N1 and N2 are turned on. The turned-on transistors N1 and N2 can overpower transistor P23 and current generator 290. Transistors N1 and N2 couple node 131 to supply node 199 and deactivate circuit path 251' (e.g., disable circuit path 251' from conducting current). This causes X = "1" (written in a previous write state) to change to the intended written value X = "0" (which corresponds to the value of voltage V0 at supply node 199) in the current write state.

Latch 201 can include improvements and benefits like latch 101. Further, the inclusion of circuits 230, 251, and 252 allows latch 201 to retain data information X at node 131 for a relatively longer time interval (e.g., more than one clock period clock signals CLK and CLK*) than that of some conventional dynamic latches.

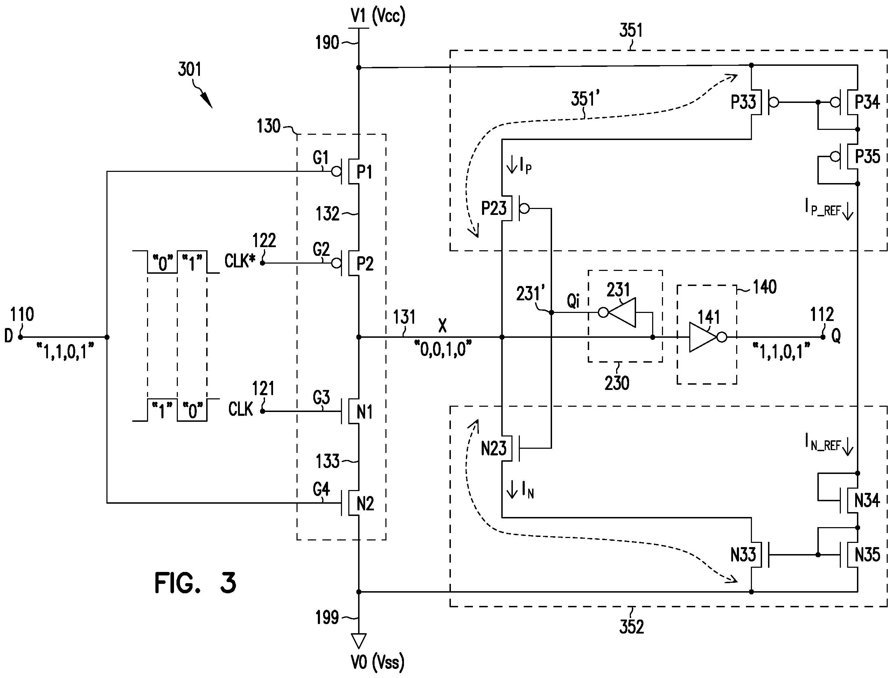

FIG. 3 shows an apparatus in the form of a latch 301, according to some embodiments described herein. Latch 301 is a dynamic latch. Latch 301 can include some elements that are similar to (or the same as) the elements of latch 201 of FIG. 2. Similar or the same elements between latches 201 and 301 are given the same labels. For example, like latch 201 in FIG. 2, latch 301 in FIG. 3 can include input stage 130 (e.g., transistors P1, P2, N1, and N2), output stage (e.g., inverter 141) 140, and circuit 230. For simplicity, descriptions of similar or the same elements between latches 201 and 301 are not repeated. As shown in FIG. 3, latch can include circuits 351 and 352. Latch 301 can operate like latch 201 in that part of circuits 351 and 352 can form (or can be) part of current generator 290 and current generator 299, respectively, of latch 201 of FIG. 2. Latch 301 can include improvements and benefits like latch 201 of FIG. 2.

As shown in FIG. 3, circuit 351 can include transistors (e.g., PMOS transistors) P33, P34, and P35 coupled to transistor P23. Transistors P23 and P33 can be coupled in series between node (e.g., memory node) 131 and supply node 190. Transistors P23, P33, P34, and P35 can form a current mirror (current mirror circuit). Transistors P23 and P33 can form part of (e.g., a branch of) the current mirror. Transistors P34 and P35 can form another part of (e.g., another branch of) the current mirror. Circuit 351 can generate current Iₚ on a circuit path (e.g., a current path) 351' between node 131 and supply node 190. Transistor P23 is part of (is included in) circuit path 351'. The value of current Iₚ can be based on (e.g., can be a mirrored current of) a current (e.g., a reference current) I_{P_REF}.

Circuit 351 and circuit 230 can operate to allow latch 301 to compensate charge leakage that may occur at node 131 to keep the value of data information X at node 131 valid for a relatively longer time interval. For example, when node 131 has X = "1", Qi = "0". Qi = "0" causes transistor P23 to turn on. The turned-on transistor P23 activates circuit path 351' to allow an amount of charge (e.g., in the form of current I_{P}) to go from supply node 190 to node 131 through circuit path 351'. This amount of charge can compensate the amount of charge going from node 131 to supply node 199 caused by charge leakage that may occur at transistor N1 (through transistor N2). This compensation can retain the value of X = "1" at node 131 for a relatively longer time interval (e.g., longer than that of latch 301 without circuit 251).

As shown in FIG. 3, circuit 352 can include transistors (e.g., NMOS transistors) N33, N34, and N35 coupled to transistor N23. Transistors N23 and N33 can be coupled in series between nodes 131 and supply node 199. Transistors N23, N33, N34, and N35 can form a current mirror (current mirror circuit). Transistors N23 and N33 can form part of (e.g., a branch of) the current mirror. Transistors N34 and N35 can form another part of (e.g., another branch of) the current mirror. Circuit 351 can generate current I_{N} on a circuit path (e.g., a current path) 352' between node 131 and supply node 199. Transistor N23 is part of (is included in) circuit path 352'. The value of current I_{N} can be based on (e.g., can be a mirrored current of) a current (e.g., a reference current) I_{N_REF}.

Circuit 352 and circuit 230 can operate to allow latch 301 to compensate charge leakage that may occur at node 131 to keep the value of data information X at node 131 valid for a relatively longer time interval. For example, when node 131 has X = "0", Qi = "1". Qi = "1" causes transistor N23 to turn on. The turned-on transistor N23 activates circuit path 352' to allow an amount of charge (e.g., in the form of current I_{N}) to go from node 131 to supply node 199 through circuit path 352'. This amount of charge can compensate the amount of charge going from supply node 190 to node 131 caused by charge leakage that may occur at transistor P2 (through transistor P1). This compensation can retain the value of X = "0" at node 131 for a relatively longer time interval (e.g., longer than that of latch 301 without circuit 252).

Latch 301 can include similar improvements and benefits over some conventional dynamic latches like latches 101 and 201. Further, the bias scheme in circuits 351 and 352 is a relatively low power bias scheme and can be shared by multiple latches like latches 301. This can provide a power saving (e.g., static power saving) in circuitry that includes latches like latch 301.

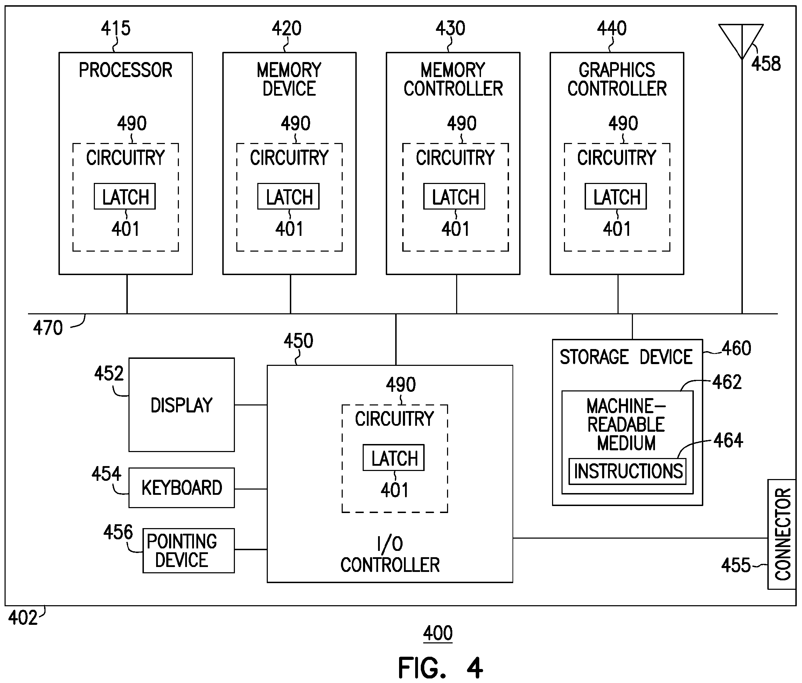

FIG. 4 shows an apparatus in the form of a system (e.g., electronic system) 400, according to some embodiments described herein. System 400 can be viewed as a machine. System (e.g., machine) 400 can include or be included in a computer, a cellular phone, or other electronic systems. As shown in FIG. 4, system 400 can include components (e.g., devices) located on a circuit board (e.g., a printed circuit board (PCB)) 402. The components can include a hardware processor 415, a memory device 420, a memory controller 430, a graphics controller 440, an input and output (I/O) controller 450, a display 452, a keyboard 454, a pointing device 456, at least one antenna 458, a storage device 460, and a bus 470. The system 400 may be configured to perform one or more of the methods and/or operations described herein.

Hardware Processor 415 can include a general-purpose processor or an application specific integrated circuit (ASIC). Hardware Processor 415 can include a central processing unit (CPU) and processing circuitry. Graphics controller 440 can include a graphics processing unit (GPU) and processing circuitry. Memory device 420 can include a dynamic random-access memory (DRAM) device, a static random-access memory (SRAM) device, a flash memory device, phase change memory, or a combination of these memory devices, or other types of memory. FIG. 4 shows an example where memory device 420 is a stand-alone memory device separated from hardware processor 415. In an alternative structure, memory device 420 and hardware processor 415 can be located on the same integrated circuit (IC) chip (e.g., a semiconductor die or IC die). In such an alternative structure, memory device 420 is an embedded memory in hardware processor 415, such as embedded DRAM (eDRAM), embedded SRAM (eSRAM), embedded flash memory, or another type of embedded memory.

Storage device 460 can include drive unit (e.g., hard disk drive (HHD), solid-state drive (SSD), or another mass storage device). Storage device 460 can include a machine-readable medium 462 and processing circuitry. Machine-readable medium 462 can store one or more sets of data structures or instructions 464 (e.g., software) embodying or used by any one or more of the techniques or functions described herein. Instructions 464 may also reside, completely or at least partially, within memory device 420, memory controller 430, hardware processor 415, or graphics controller 440 during execution thereof by system (e.g., machine) 400.

In an example, one of (or any combination of) hardware processor 415, memory 420, memory controller 430, graphics controller 440, and storage device 460 may constitute machine-readable media. Non-limiting machine-readable medium examples may include solid-state memories and optical and magnetic media. Specific examples of machine-readable media may include non-volatile memory, such as semiconductor memory devices (e.g., EPROM or EEPROM) and flash memory devices; magnetic disks, such as internal hard disks and removable disks; magneto-optical disks; RAM; and CD-ROM and DVD-ROM disks.

FIG. 4 shows machine-readable medium 462 as a single medium as an example. However, the term "machine-readable medium" may include a single medium or multiple media (e.g., a centralized or distributed database, and/or associated caches and servers) configured to store instructions 464. Further, the term "machine-readable medium" may include any medium that is capable of storing, encoding, or carrying instructions for execution by system 400 and that causes system 400 to perform any one or more of the techniques of the present disclosure, or that is capable of storing, encoding or carrying data structures used by or associated with such instructions. In some examples, machine-readable media may include non-transitory machine-readable media. In some examples, machine-readable media may include machine-readable media that is not a transitory propagating signal.

Display 452 can include a liquid crystal display (LCD), a touchscreen (e.g., capacitive or resistive touchscreen), or another type of display. Pointing device 456 can include a mouse, a stylus, or another type of pointing device. In some structures, system 400 does not have to include a display. Thus, in such structures, display 452 can be omitted from system 400.

Antenna 458 can include one or more directional or omnidirectional antennas, including, for example, dipole antennas, monopole antennas, patch antennas, loop antennas, microstrip antennas, or other types of antennas suitable for transmission of radio frequency (RF) signals. In some structures, system 400 does not have to include an antenna. Thus, in such structures, antenna 458 can be omitted from system 400.

I/O controller 450 can include a communication module for wired or wireless communication (e.g., communication through one or more antennas 458). Such wireless communication may include communication in accordance with WiFi communication technique, Long Term Evolution Advanced (LTE-A) communication technique, or other communication techniques.

I/O controller 450 can also include a module to allow system 400 to communicate with other devices or systems in accordance with to one or more of the following standards or specifications (e.g., I/O standards or specifications), including Universal Serial Bus (USB), DisplayPort (DP), High-Definition Multimedia Interface (HDMI), Thunderbolt, Peripheral Component Interconnect Express (PCIe), Ethernet, and other specifications.

Connector 455 can include terminals (e.g., pins) to allow system 400 to be coupled to an external device (or system). This may allow system 400 to communicate (e.g., exchange information) with such a device (or system) through connector 455. Connector 455 and at least a portion of bus 470 can include conductive lines that conform with at least one of USB, DP, HDMI, Thunderbolt, PCIe, Ethernet, and other specifications.

FIG. 4 shows the components (e.g., devices) of system 400 arranged separately from each other as an example. For example, each of hardware processor 415, memory device 420, memory controller 430, graphics controller 440, and I/O controller 450 can be included in (e.g., formed in or formed on) a separate integrated circuit (IC) chip (e.g., separate semiconductor die or separate IC die). In some structures of system 400, two or more components (e.g., hardware processor 415, memory device 420, graphics controller 440, and I/O controller 450) of system 400 can be included in (e.g., formed in or formed on) the same IC chip (e.g., same semiconductor die), forming a system-on-chip (SoC), or alternatively, a system in a package (SiP).

As shown in FIG. 4, each of hardware processor 415, memory device 420, memory controller 430, graphics controller 440, and I/O controller 450 can include circuitry 490. Circuitry 490 can include a relatively high-speed digital logic circuitry. Circuitry 490 can include a clock distribution network, a data path, or both. Each of the clock distribution network and the data path of circuitry 490 can include a latch 401. Latch 401 can include any of latches 101, 201, and 301 described above with reference to FIG. 1, FIG. 2, and FIG. 3. In an alternative structure of system 400, either the clock distribution network or the data path (mentioned above) can be eliminated from circuitry 490 of at least one of hardware processor 415, memory device 420, memory controller 430, graphics controller 440, and I/O controller 450. In another alternative structure of system 400, circuitry 490 can be eliminated from some of hardware processor 415, memory device 420, memory controller 430, graphics controller 440, and I/O controller 450. A device (e.g., hardware processor 415, memory device 420, memory controller 430, graphics controller 440, or I/O controller 450 of system 400) or a system (e.g., system 400) that includes a latch like latch 401 can have improvements and benefits similar to those of latch 101, 201, and 301 described above with reference to FIG. 1, FIG. 2, and FIG. 3.

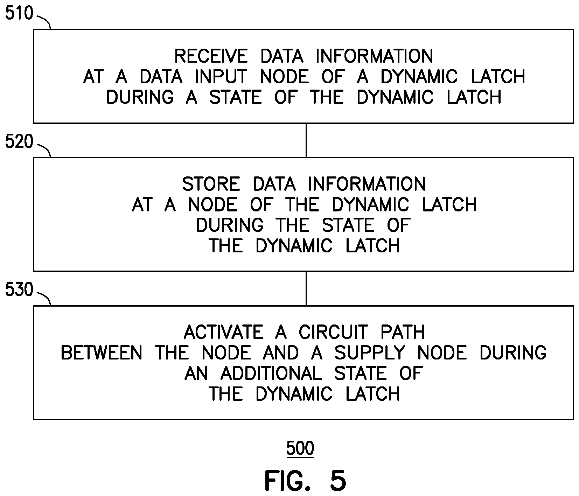

FIG. 5 is a flowchart showing a method 500 of operating an apparatus, according to some embodiments described herein. The apparatus used in method 500 can include any of the apparatuses (e.g., latches 101, 201, and 301 and system 400) described above with reference to FIG. 1 through FIG. 4. Some of the activities in method 500 may be performed by hardware, software, firmware, or any combination of hardware, software, and firmware of a device (e.g., processor 415, memory device 420, memory controller 430, graphics controller 440, or I/O controller 450 of system 400) or a system (e.g., system 400). In an example, some of the activities in method 500 may be performed by circuitry (e.g., circuitry 490 that includes at least one of a clock distribution network and a data path) of a device (e.g., processor 415, memory device 420, memory controller 430, graphics controller 440, or I/O controller 450) or system (e.g., system 400). At least part of the activities (e.g., operations) of method 500 can be performed by a latch of the circuitry in which the latch can include one of latches 101, 201, and 301 described above with reference to FIG. 1 through FIG. 4.

As shown in FIG. 5, method 500 can include activities (e.g., operations) 510, 520, and 530. Activity 510 can include receiving data information at a data input node of a dynamic latch during a state (e.g., a write state) of the dynamic latch (e.g., one of latches 101, 201, and 301 described above with reference to FIG. 1 through FIG. 4). The data input node can include node 110 of one of latches 101, 201, and 301. Activity 520 can include storing data information at a node of the dynamic latch during the state (e.g., a write state) of the dynamic latch. The node of the dynamic latch can include a charge storage node (e.g., a memory node) of the dynamic latch (e.g., node 131 of one of latches 101, 201, and 301). Activity 530 can include activating a circuit path (e.g., a current path) coupled between the node and a supply node during an additional state (e.g., a retention state) of the dynamic latch. The circuit path can include any of circuit path 151', 152', 251', 252', 351', and 352' of respective latches 101, 201, and 301 described above with reference to FIG. 1 through FIG. 4. Activating the circuit path in activity 530 of method 500 can include turning on a transistor of the circuit path. The transistor can be one of transistors P13, N13, P23, and N23 of respective latches 101, 201, and 301 described above with reference to FIG. 1 through FIG. 4. The gate of the transistor in activity 530 can be controlled based on a value of the information at the node in the additional state.

Method 500 can include fewer or more activities relative to activities 510, 520, and 530 in FIG. 5. For example, method 500 can include activities and operations of the apparatuses (e.g., latches 101, 201, and 301 and system 400) described above with reference to FIG. 1 through FIG. 4. Thus, method 500 can have improvements and benefits similar to those of latch 101, 201, and 301 described above with reference to FIG. 1 through FIG. 4.

The illustrations of the apparatuses (e.g., latches 101, 201, and 301 and system 400) described and methods (e.g., operations of latches 101, 201, and 301 and system 400 and methods of operating latches 101, 201, and 301 and system 400) described above are intended to provide a general understanding of the structure of different embodiments and are not intended to provide a complete description of all the elements and features of an apparatus that might make use of the structures described herein. An apparatus herein refers to, for example, either a device (e.g., latch 101, 201, or 301, processor 415, memory device 420, memory controller 430, graphics controller 440, or I/O controller 450) or a system (e.g., system 400).

Any of the components described above with reference to FIG. 1 through FIG. 5 can be implemented in a number of ways, including simulation via software. Thus, apparatuses described above may all be characterized as "modules" (or "module") herein. Such modules may include hardware circuitry, single- and/or multi-processor circuits, memory circuits, software program modules and objects and/or firmware, and combinations thereof, as desired and/or as appropriate for particular implementations of various embodiments. For example, such modules may be included in a system operation simulation package, such as a software electrical signal simulation package, a power usage and ranges simulation package, a capacitance-inductance simulation package, a power/heat dissipation simulation package, a signal transmission-reception simulation package, and/or a combination of software and hardware used to operate or simulate the operation of various potential embodiments.

The apparatuses and methods described above can include or be included in high-speed computers, communication and signal processing circuitry, single- or multi-processor modules, single or multiple embedded processors, multicore processors, message information switches, and application-specific modules including multilayer, multichip modules. Such apparatuses may further be included as subcomponents within a variety of other apparatuses (e.g., electronic systems), such as televisions, cellular telephones, personal computers (e.g., laptop computers, desktop computers, handheld computers, tablet computers, etc.), workstations, radios, video players, audio players (e.g., MP3 (Motion Picture Experts Group, Audio Layer 3) players), vehicles, medical devices (e.g., heart monitor, blood pressure monitor, etc.), set top boxes, and others.

In the detailed description and the claims, the terms "first," "second," and "third," etc. are used merely as labels, and are not intended to impose numerical requirements on their objects.

In the detailed description and the claims, the term "adjacent" generally refers to a position of a thing being next to (e.g., either immediately next to or close to with one or more things between them) or adjoining another thing (e.g., abutting it or contacting it (e.g., directly coupled to) it).

In the detailed description and the claims, a list of items joined by the term "at least one of' can mean any combination of the listed items. For example, if items A and B are listed, then the phrase "at least one of A and B" means A only; B only; or A and B. In another example, if items A, B, and C are listed, then the phrase "at least one of A, B and C" means A only; B only; C only; A and B (excluding C); A and C (excluding B); B and C (excluding A); or all of A, B, and C. Item A can include a single element or multiple elements. Item B can include a single element or multiple elements. Item C can include a single element or multiple elements.

In the detailed description and the claims, a list of items joined by the term "one of' can mean only one of the list items. For example, if items A and B are listed, then the phrase "one of A and B" means A only (excluding B), or B only (excluding A). In another example, if items A, B, and C are listed, then the phrase "one of A, B and C" means A only; B only; or C only. Item A can include a single element or multiple elements. Item B can include a single element or multiple elements. Item C can include a single element or multiple elements.

Described implementations of the subject matter can include one or more features, alone or in combination as illustrated below by way of examples.

Example 1 is an apparatus comprising: an input stage of a latch to receive input data information and clock information, a memory node coupled to the input stage to store data information based on the input data information, an output stage of the latch coupled to the memory node and including an output node to provide output data information based on the data information stored at the memory node, a first circuit to provide a first circuit path between the memory node and a first node in the input stage, and a second circuit to provide a second circuit path between the memory node and a second node in the input stage.

In Example 2, the subject matter of Example 1 includes subject matter wherein the input stage includes transistors coupled in series with each other between a first supply node and a second supply node, the transistors include respective gates, and at least one of the gates of the transistors is to receive the input data information.

In Example 3, the subject matter of Example 2 includes subject matter wherein at least one of the gates of the transistors is to receive the clock information.

In Example 4, the subject matter of any of Examples 1-3 includes subject matter wherein the first circuit includes a first additional transistor, the first additional transistor including a first terminal coupled to the memory node, a second terminal coupled to the first node in the input stage, and a gate coupled to the output node.

In Example 5, the subject matter of any of Examples 1-4 includes subject matter wherein the second circuit includes a second additional transistor, the second additional transistor including a first terminal coupled to the memory node, a second terminal coupled to the second node in the input stage, and a gate coupled to the output node.

In Example 6, the subject matter of Example 5 includes subject matter wherein the first and second additional transistors have different transistor types.

In Example 7, the subject matter of Example 5 includes subject matter wherein the first additional transistor is an n-type transistor, and the second additional transistor is a p-type transistor.

In Example 8, the subject matter of any of Examples 1-3 includes subject matter wherein the first circuit includes a p-channel transistor including a first terminal couple to the memory node, a second terminal coupled to the first node, and a gate coupled to the output node, and the second circuit includes an n-type transistor including a first terminal couple to the memory node, a second terminal coupled to the second node, and a gate coupled to the output node.

In Example 9, the subject matter of any of Examples 1-8 includes subject matter wherein input stage includes a first clock node to receive a first clock signal of the clock information, a second clock node to receive a second clock signal of the clock information, a first transistor having a gate coupled to the first clock node, and a second transistor having a gate coupled to the second clock node.

In Example 10, the subject matter of Example 9 includes subject matter wherein the second clock signal is an inversion of the first clock signal.

In Example 11, the subject matter of Example 1 includes subject matter wherein the input stage includes a data node to receive the input data information, a first transistor coupled between a first supply node and the first node, the first transistor including a gate coupled to the data node, a second transistor coupled between the first node and the memory node, the second transistor including a gate to receive a first clock signal of the clock information, a third transistor coupled between the memory node and the second node, the third transistor including a gate to receive a second clock signal of the clock information, and a fourth transistor coupled between the second node and the second supply node, the fourth transistor including a gate coupled to the data node.

In Example 12, the subject matter of Example 11 includes subject matter wherein the first and second transistors have a first transistor type, and the third and fourth transistors have a second transistor type.

In Example 13, the subject matter of Example 11 includes subject matter wherein the first and second transistors are p-type transistors, and the third and fourth transistors are n-type transistors.

In Example 14, the subject matter of any of Examples 1-13 includes subject matter wherein the apparatus comprises circuitry, the circuitry including at least one of a clock distribution network and a data path, and wherein the latch is a dynamic latch, and the at least one of a clock distribution network and a data path includes the dynamic latch.

In Example 15, the subject matter of any of Examples 1-13 includes subject matter wherein apparatus comprises an integrated circuit (IC) chip, the IC chip including the input stage, the memory node, the output stage, the first circuit, and the second circuit.

In Example 16, the subject matter of any of Examples 1-13 includes subject matter wherein the apparatus comprises a processor, the processor including the input stage, the memory node, the output stage, the first circuit, and the second circuit.

Example 17 is an apparatus comprising: an input stage of a latch to receive input data information and clock information, the input stage coupled to a first supply node and a second supply node, a memory node coupled to the input stage to store data information based on the input data information, an output stage of the latch coupled to the memory node and including an output node to provide output data information based on the data information stored at the memory node, a first circuit to provide a first circuit path between the memory node and the first supply node, a second circuit to provide a second circuit path between the memory node and the second supply node, and a third circuit to provide control information to the first circuit and the second circuit based on the information stored at the memory node.

In Example 18, the subject matter of Example 17 includes subject matter wherein the first circuit includes at least one transistor coupled between the memory node and the first supply node, the second circuit includes at least one transistor coupled between the memory node and the second supply node, and the third circuit includes an inverter, the inverter including an input node coupled to the memory node and an output node coupled to a gate of a transistor of the first circuit and a gate of a transistor of the second circuit

In Example 19, the subject matter of Example 17 includes subject matter wherein the first circuit includes at least one transistor coupled between the memory node and the first supply node, and the second circuit includes at least one transistor coupled between the memory node and the second supply node.

In Example 20, the subject matter of Example 19 includes subject matter wherein the at least one transistor coupled between the memory node and the first supply node has a first transistor type, and the at least one transistor coupled between the memory node and the second supply node has a second transistor type.

In Example 21, the subject matter of any of Examples 19-20 includes subject matter wherein the least one transistor of the first circuit includes first transistors coupled in series between the memory node and the first supply node, and the least one transistor of the second circuit includes second transistors coupled in series between the memory node and the second supply node.

In Example 22, the subject matter of Example 21 includes subject matter wherein the first transistors have first a transistor type, and the second transistors have a second transistor type.

In Example 23, the subject matter of any of Examples 17-22 includes subject matter wherein the first circuit includes a first current generator coupled between the memory node and the first supply node, and the second circuit includes a second current generator coupled between the memory node and the second supply node.

In Example 24, the subject matter of any of Examples 17-23 includes subject matter wherein the first circuit includes a first current generator coupled between the memory node and the first supply node, and the second circuit includes a second current generator coupled between the memory node and the second supply node.

In Example 25, the subject matter of any of Examples 17-23 includes subject matter wherein the first circuit is part of a first current mirror, and the second circuit is part of a second current mirror.

In Example 26, the subject matter of any of Examples 17-23 includes subject matter wherein the memory node is configured to store the data information during a first phase of a clock signal of the clock information, and the memory node is configured to retain the data information during a second phase of the clock signal.

In Example 27, the subject matter of Example 17 includes subject matter wherein the input stage includes a first p-type transistor coupled between a first supply node and the first node, the first p-type transistor including a gate to receive the input data information, a second p-type transistor coupled between the first node and the memory node, the second p-type transistor including a gate to receive a first clock signal of the clock information, a first n-type transistor coupled between the memory node and the second node, the first n-type transistor including a gate to receive a second clock signal of the clock information, and a second n-type transistor coupled between the second node and the second supply node, the second n-type transistor including a gate to receive the input data information

In Example 28, the subject matter of any Example 17-27 includes subject matter wherein apparatus comprises a system-on-chip (SoC), the SoC includes an integrated circuit (IC) chip, the IC chip includes the input stage, the memory node, the output stage, the first circuit, the second circuit, and the third circuit.

In Example 29, the subject matter of any of Examples 17-27 includes, a connector and an integrated circuit (IC) chip coupled to the connector, the IC chip including the input stage, the memory node, the output stage, the first circuit, the second circuit, and the third circuit, wherein the connector conforms with at least one of Universal Serial Bus (USB), High-Definition Multimedia Interface (HDMI), Thunderbolt, Peripheral Component Interconnect Express (PCIe), and Ethernet specifications.

Example 30 is a method comprising: receiving input data information at a data input node of a dynamic latch during a first state of the dynamic latch, storing data information at a node of the dynamic latch during the first state, the data information at the node having a value based on a value of the input data information at the data input node, and activating a circuit path coupled between the node and a supply node during a second state of the dynamic latch.

In Example 31, the subject matter of Example 30 includes subject matter wherein activating the circuit path includes turning on a transistor of the circuit path, and wherein a gate of the transistor is controlled based on a value of the data information at the node in the second state.

In Example 32, the subject matter of any of Examples 30-31 includes subject matter wherein activating the circuit path includes turning on a p-type transistor of the circuit path.

In Example 33, the subject matter of any of Examples 30-31 includes subject matter wherein activating the circuit path includes turning on an n-type transistor of the circuit path.

In Example 34, the subject matter of Example 30, includes activating an additional circuit path coupled between the node and an additional supply node during an additional state of the dynamic latch includes subject matter wherein the first state of the latch is a first write state of the latch, and the additional state of the latch is a second write state of the latch.

In Example 35, the subject matter of any of Examples 30-33 includes subject matter wherein a bit of data information at the data input node during the first write state has a first binary value, and a bit of data information at the node of the dynamic latch during the first state has a second binary value.

Example 36 is at least one machine-readable medium including instructions that, when executed by processing circuitry, cause the processing circuitry to perform operations to implement any of Examples 1-35.

Example 37 is an apparatus comprising means to implement any of Examples 1-35.

Example 38 is a system to implement any of Examples 1-35.

Example 39 is a method to implement any of Examples 1-35.

The above description and the drawings illustrate some embodiments of the inventive subject matter to enable those skilled in the art to practice the embodiments of the inventive subject matter. Other embodiments may incorporate structural, logical, electrical, process, and other changes. Examples merely typify possible variations. Portions and features of some embodiments may be included in, or substituted for, those of others. Many other embodiments will be apparent to those of skill in the art upon reading and understanding the above description

The Abstract is provided to allow the reader to ascertain the nature and gist of the technical disclosure. It is submitted with the understanding that it will not be used to limit or interpret the scope or meaning of the claims. The following claims are hereby incorporated into the detailed description, with each claim standing on its own as a separate embodiment.

## Claims

1. An apparatus comprising:
an input stage of a latch to receive input data information and clock information;
a memory node coupled to the input stage to store data information based on the input data information;
an output stage of the latch coupled to the memory node and including an output node to provide output data information based on the data information stored at the memory node;
a first circuit to provide a first circuit path between the memory node and a first node in the input stage; and
a second circuit to provide a second circuit path between the memory node and a second node in the input stage.

2. The apparatus of claim 1, wherein the input stage includes transistors coupled in series with each other between a first supply node and a second supply node, the transistors include respective gates, and at least one of the gates of the transistors is to receive the input data information;
preferably wherein at least one of the gates of the transistors is to receive the clock information.

3. The apparatus of claim 2, wherein:
the first circuit includes a first additional transistor, the first additional transistor including a first terminal coupled to the memory node, a second terminal coupled to the first node in the input stage, and a gate coupled to the output node; and/or
the second circuit includes a second additional transistor, the second additional transistor including a first terminal coupled to the memory node, a second terminal coupled to the second node in the input stage, and a gate coupled to the output node.

4. The apparatus of any one of claims 1 to 3, wherein the input stage includes:
a first clock node to receive a first clock signal of the clock information;
a second clock node to receive a second clock signal of the clock information;
a first transistor having a gate coupled to the first clock node; and
a second transistor having a gate coupled to the second clock node.

5. The apparatus of any one of claims 1 to 4, wherein the input stage includes a data node to receive the input data information;
a first transistor coupled between a first supply node and the first node, the first transistor including a gate coupled to the data node;
a second transistor coupled between the first node and the memory node, the second transistor including a gate to receive a first clock signal of the clock information;
a third transistor coupled between the memory node and the second node; the third transistor including a gate to receive a second clock signal of the clock information; and
a fourth transistor coupled between the second node and the second supply node, the fourth transistor including a gate coupled to the data node.

6. The apparatus of any one of claims 1 to 5, wherein the apparatus comprises circuitry, the circuitry including at least one of a clock distribution network and a data path, and wherein the latch is a dynamic latch, and the at least one of a clock distribution network and a data path includes the dynamic latch; and/or
wherein the apparatus comprises a processor, the processor including the input stage, the memory node, the output stage, the first circuit, and the second circuit.

7. An apparatus comprising:
an input stage of a latch to receive input data information and clock information, the input stage coupled to a first supply node and a second supply node;
a memory node coupled to the input stage to store data information based on the input data information;
an output stage of the latch coupled to the memory node and including an output node to provide output data information based on the data information stored at the memory node;
a first circuit to provide a first circuit path between the memory node and the first supply node;
a second circuit to provide a second circuit path between the memory node and the second supply node; and
a third circuit to provide control information to the first circuit and the second circuit based on the information stored at the memory node.

8. The apparatus of claim 7, wherein:
the first circuit includes at least one transistor coupled between the memory node and the first supply node;
the second circuit includes at least one transistor coupled between the memory node and the second supply node; and
the third circuit includes an inverter, the inverter including an input node coupled to the memory node and an output node coupled to a gate of a transistor of the first circuit and a gate of a transistor of the second circuit.

9. The apparatus of any one of claims 7 or 8, wherein:
the first circuit includes a first current generator coupled between the memory node and the first supply node; and
the second circuit includes a second current generator coupled between the memory node and the second supply node.

10. The apparatus of any one of claims 7 to 9,
wherein the first circuit is part of a first current mirror; and wherein the second circuit is part of a second current mirror; and/or
wherein the memory node is configured to receive data information during a first phase of a clock signal of the clock information; and wherein the memory node is configured to retain the data information during a second phase of the clock signal.

11. The apparatus of any one of claims 7 to 10, wherein the input stage includes:
a first p-type transistor coupled between a first supply node and the first node, the first p-type transistor including a gate to receive the input data information;
a second p-type transistor coupled between the first node and the memory node, the second p-type transistor including a gate to receive a first clock signal of the clock information;
a first n-type transistor coupled between the memory node and the second node; the first n-type transistor including a gate to receive a second clock signal of the clock information; and
a second n-type transistor coupled between the second node and the second supply node, the second n-type transistor including a gate to receive the input data information.

12. The apparatus of any one of claims 7 to 11, further comprising a connector and an integrated circuit (IC) chip coupled to the connector, the IC chip including the input stage, the memory node, the output stage, the first circuit, the second circuit, and the third circuit, wherein the connector conforms with at least one of Universal Serial Bus (USB), High-Definition Multimedia Interface (HDMI), Thunderbolt, Peripheral Component Interconnect Express (PCIe), and Ethernet specifications.

13. A method comprising:
receiving input data information at a data input node of a dynamic latch during a first state of the dynamic latch;
storing data information at a node of the dynamic latch during the first state, the data information at the node having a value based on a value of the input data information; and
activating a circuit path coupled between the node and a supply node during a second state of the dynamic latch.

14. The method of claim 13, wherein activating the circuit path includes turning on a transistor of the circuit path; and
wherein a gate of the transistor is controlled based on a value of the data information at the node in the second state.

15. The method of any one of claims 13 or 14, wherein activating the circuit path includes turning on a p-type transistor of the circuit path; or
wherein activating the circuit path includes turning on an n-type transistor of the circuit path.
